Europäisches Patentamt

European Patent Office

Office européen des brevets

(11) Publication number: **0 222 942**
**B1**

# (12) EUROPEAN PATENT SPECIFICATION

(45) Date of publication of the patent specification:
17.01.90

(21) Application number: 85308005.9

(22) Date of filing: 04.11.85

(51) Int. Cl.⁴: **H03M 7/42**

(54) Variable word length decoder.

(43) Date of publication of application:
27.05.87 Bulletin 87/22

(45) Publication of the grant of the patent:
17.01.90 Bulletin 90/3

(84) Designated Contracting States:
AT DE FR GB NL SE

(56) References cited:
US-A- 4 101 934
US-A- 4 396 906

(73) Proprietor: **NORTHERN TELECOM LIMITED, 600 de la Gauchetiere Street West, Montreal Quebec H3B 4N7(CA)**

(72) Inventor: **Bahgat, Osama Abu El-Kheir Hussein, 520 Landreville Apt. 1M Nun's Island, Verun Quebec, H3E 1B4(CA)**

(74) Representative: **Crawford, Andrew Birkby et al, A.A. THORNTON & CO. Northumberland House 303-306 High Holborn, London WC1V 7LE(GB)**

ACTORUM AG

## Description

The invention relates to variable word length decoders for digital signals and is especially, but not exclusively, applicable to predictive differential pulse code nodulation systems for video or voice transmission and/or storage.

In such systems it is generally desirable to reduce the number of bits needed to be transmitted or stored while preserving the integrity of the reconstituted signal. In predictive systems this is achieved by transmitting a prediction error signal representing the difference between an instant signal element value and a predicted value derived from a number of preceding signal elements. There is usually a strong correlation between neighbouring values of a video or voice signal so the predicted value will generally be very close to the instant value. Consequently it is more probable that the prediction error signal will be zero, or small, than large. Nevertheless, the system must be capable of handling large prediction error signals as and when they occur. Hence, if the prediction error signal is quantized, the outer levels of the quantizer are rarely used.

In order to avoid such inefficient use of the system capacity, it has been proposed to apply the prediction error signal to a variable word length coder which has shorter words assigned to the inner levels around zero, where the probability of data generation is high. Thus, on average. efficient transmission is achieved.

An association encoder is described in a copending application entitled "Variable word length encoder" having European Patent Application serial number 85 308 006.7 and publication number EP-A 0 222 943.

According to the present invention there is provided apparatus for decoding variable word length encoded serial binary data to provide for each variable length word a corresponding parallel binary word, each non-zero variable length word comprising a start bit and a stop bit of one state and a number of other bits of a different state, the number of said other bits representing the magnitude of the word, the apparatus comprising a binary counter and means responsive to a start bit of a variable length word to be decoded for clearing the counter enabling the counter to count any said other bits present, responsive to a stop bit of said variable word to output the contents of the counter as the corresponding parallel binary output word, responsive to said stop bit for loading the counter with a predetermined number and responsive to a following zero value variable length word to output said predetermined number from said counter.

Preferably such other bits are between the start bit and the stop bit.

In preferred embodiments of the invention the number of said other bits is numerically one less than the magnitude represented and the apparatus includes an adder to add unity to the output of the counter.

The means responsive to said start and stop bits may also be responsive to each stop bit to load the counter with all ones. Then, if the next word is non-zero, the counter will be cleared and the "other" bits counted. On the other hand, if the next word is zero, the counter output will be taken, and a one added to it to give an all-zero output word.

The means responsive to the start and stop bits may comprise detection means for detecting the start and stop bits and control means for controlling the operation of the counter and of the detection means. More specifically the control means may control application to the detection means and counter, for example using gates, of a signal corresponding to the input word derived from input means controlled by a clock or periodic timing signal.

The apparatus may include means for detecting an additional bit representing, for example, the polarity of the input variable length word and for inserting a corresponding sign bit in the output word.

An exemplary embodiment of the invention will now be described with reference to the accompanying drawings, in which:

figure 1 is a schematic representation of a variable word decoder,

figure 2 is a more detailed representation of the decoder and

figures 3A and 3B show a timing diagram for the decoder.

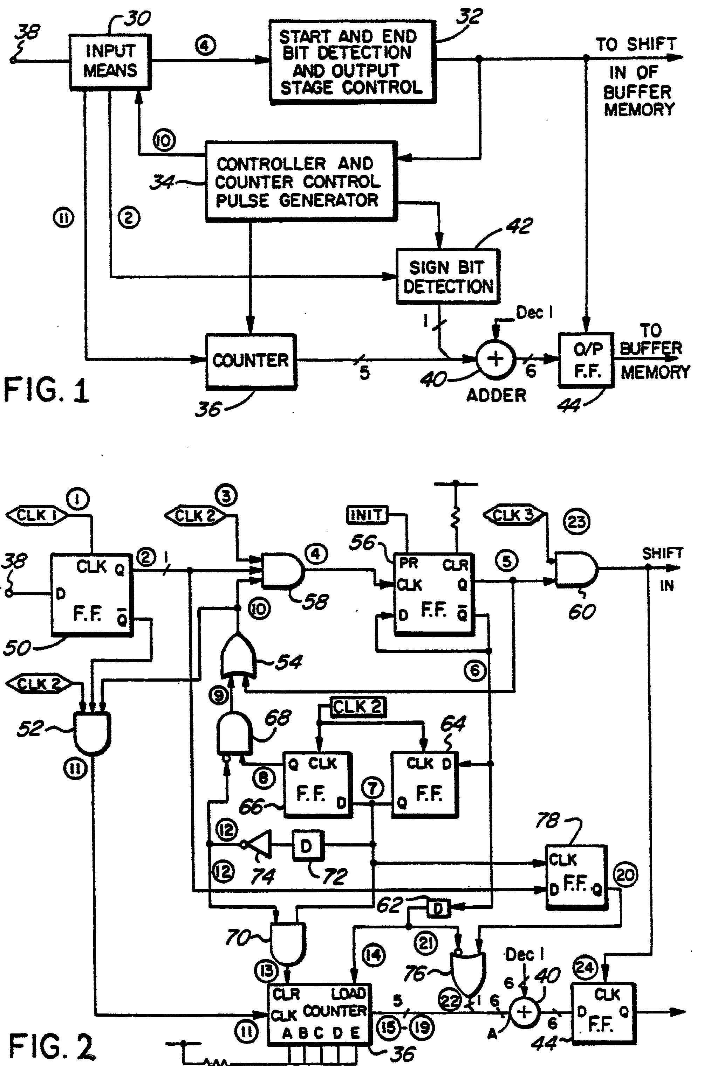

Referring now to figure 1, a decoder for converting serial variable word length (VWL) coded data to parallel binary form (see table 1) comprises input means 30 which responds to the input variable length word and to first and second periodic timing signals or clock CLK1 and CLK2 to provide corresponding signals 2, 4 and 11 (see figure 2 ) for application to a sign bit detection means 42, a start and stop bit detection means 32, and to a counter 36, respectively. A controller 34, responsive to the output of the detection means 32, controls application of the signals 4 and 11 to the detection means 32 and counter 36, and also serves to apply pulses to the clear (CLR) input of the counter 36 so as to clear it at the beginning of each non-zero word.

The output of the counter 36 comprises five bits which are supplied by way of a five line bus to one input of an adder 40. A sixth bit, derived from sign bit detection means 42, is applied, as the most significant bit, to the same input of the adder 40.

The second input of adder 40 is arranged to receive the binary (000001), representing decimal one. The output of the adder 40 is applied by way of a six line bus to output means 44 which is controlled by detection means 32 to latch the output of the adder 40, when the end bit of the variable length input word is received. The output means 44 may supply the parallel signed binary word to a buffer memory (not shown).

As previously described, there are three types of variable words, namely a single zero; a non-zero word comprising a start bit, an end bit and a polarity or sign bit and having magnitude of unity; a non-zero word comprising a start bit, a polarity bit and an end bit, with a number of zero bits representing a magnitude greater than unity.

For a non-zero input word, the output of counter 36 is a five bit binary word representing the number of zeros in the variable length word at the input means 30. The sign bit, 1 or 0, is joined as the sixth bit. Then, since the number of zeros is equal to one less than the magnitude (see table 1), decimal 1 is added to the six bit word by adder 40.

Reference to table 1 will show that the variable length word representing zero magnitude is a single zero and that its corresponding parallel binary word is (000000). To achieve this conversion, start and stop bit detection means 32 loads the counter 36 with (11111) and controller 34 inhibits application of the input means 30 output to the CLK input of counter 36. In addition, means 32 forces a polarity bit of 1 to be produced by sign bit detector 42. Accordingly, the six bit word applied to adder 40 is (111111) which, after addition of 1 gives (000000) as the parallel signed binary output word corresponding to zero magnitude.

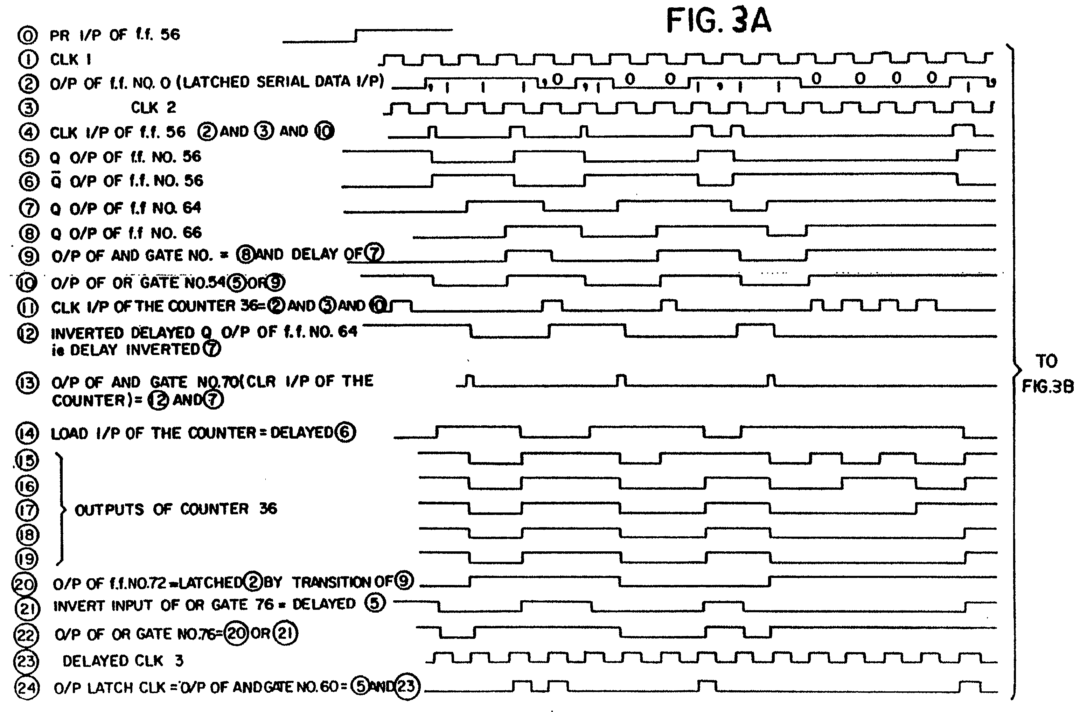

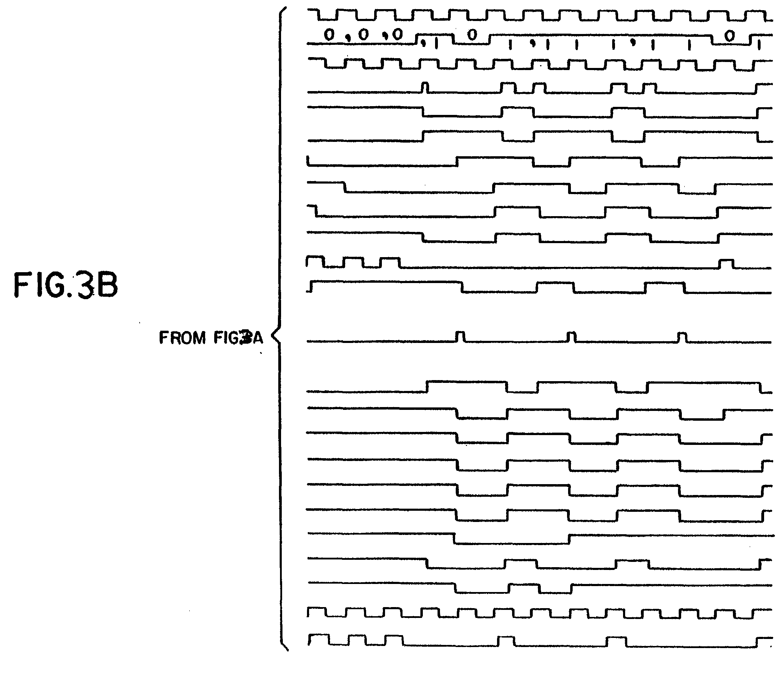

The decoder is illustrated in more detail in figure 2. Input means 30 comprises a flip-flop 50 and three-input AND gates 52 and 58. The D input of flip-flop 50 is connected to the circuit serial VWL data input 38 and its Q and $\bar{Q}$ outputs are connected to inputs of AND gates 58 and 52, respectively. The flip-flop 50 is also connected to a periodic signal or clock CLK1 and a second input of AND gates 52 and 58 are connected to a clock CLK2 which is delayed relative to clock CLK1. The delay is sufficient to compensate for edge transitions and propagation delays and so will be determined according to the clock frequency and the particular devices used. The third input of AND gates 52 and 58 are connected to the output of an OR gate 54 in the controller 34. When AND gates 58 and 52 are enabled by the OR gate 54, they pass a combination of the input signal Q and $\bar{Q}$, respectively, and clock signal CLK2, as represented by signals 4 and 11 respectively, in figures 3A and 3B. In practice gates 58 and 52 will only supply 1's when there are corresponding one and zero bits, respectively, in the input word. Gates 58 and 52 operate in a similar manner, the former (58) serving 1's in the input signal and the latter (52) serving 0's.

Start and stop bit detection means 32 comprises a flip-flop 56, and a two input AND gate 60. The Q output of flip-flop 56 is connected to one input of OR gate 54 and to one input of AND gate 60, the other input of which is connected to a third clock, CLK3, which is delayed relative to clock CLK1, again to compensate for edge transitions and propagation delays. The output of AND gate 60 is connected to the CLK input of flip-flop 44 which contains six D-type flip-flops, and comprises the output means. When AND gate 60 is enabled, the parallel binary word is latched into flip-flop 44 whose output comprises the output of the decoder.

The $\bar{Q}$ output of flip-flop 56 is connected to its D input, and by way of a delay 62 to the LOAD input of counter 36 and an inverting input of an OR gate 76, which is part of the sign bit detection means 42. The parallel data inputs of the counter 36 are connected to a source of 1's so that when the $\bar{Q}$ output of flip-flop 56 goes low, which it does at the end of every non zero word, the LOAD input goes low after a delay and the counter is filled with 1's. At the same time, since the inverting input of OR gate 76 is low, its output will be high so the six-bits applied to the adder will be (111111).

In addition to OR gate 54, previously mentioned, the controller 34 also comprises a pair of flip-flops 64 and 66, which serve as 1 bit delays, AND gates 68 and 70, delays 62 and 72, and inverter 74.

The $\bar{Q}$ output of flip-flop 56 is connected to the D input of flip-flop 64, the Q output of which is connected to the D input of flip-flop 66. Both flip-flops 64 and 66 are clocked by clock CLK2.

The Q output of flip-flop 66 is connected to one input of AND gate 68, the output of which is connected to the second input of OR gate 54. The Q output of flip-flop 64 is also connected directly to one input of AND gate 70 and indirectly, by way of delay 72 and inverter 74, to the other input of gate 70. The output of inverter 74 is also connected to an inverting input of AND gate 68.

If a zero word appears at the input to the decoder, the outputs of flip-flop 56 will not change state. Thus its $\bar{Q}$ output will stay low and the controller will not be activated, the LOAD input of the counter 36 will stay low and the counter 36 will remain loaded with 1's as previously described. However, if a non-zero word is to be decoded, the start bit will cause flip-flop 56 to change state. This results in both inputs of OR gate 54 being low which inhibits the supply of input signals to both flip-flop 56 and the counter 36. In the next bit period a low to high transition appears at the output of flip-flop 64 (signal 7). Therefore a positive going pulse will be generated at the output of AND gate 70 which clears the counter 36. In the succeeding bit period AND gate 68 is enabled, and hence OR gate 54, which enables AND gates 52 and 58 to clock the input signal to counter 36 and flip-flop 56, respectively. Providing the input signal comprises zeroes, counter 36 will count them and flip-flop 56 will not change state. When the end or stop bit occurs, however, flip-flop 56 will change state and its Q output will go high enabling gate 60. Therefore the clock signal CLK3 will appear at the output of gate 60 and the output of the adder 40 will be latched into flip-flops 44. Also its $\bar{Q}$ output will be low so, after a short delay, the counter 36 will be loaded again with ones.

EP 0 222 942 B1

In addition to OR gate 76, sign bit detection means 42 comprises a flip-flop 78 having its output connected to one input of OR gate 76. Its CLK input is connected to the Q output of flip-flop 64 and its D input is connected to the Q output of flip-flop 50 in the input means 30. The sign or polarity bit is the second bit of the variable length word so when the low to high transition (at the time of the second bit) appears at the CLK input of the sign bit flip-flop 78, it will latch whatever bit is then appearing at the D input, which is the second bit of the variable length word at the Q output of flip-flop 50. This polarity bit is then transferred by way of OR gate 76 to the adder 40 for combination with the output of the counter 36.

The operating sequence of the decoder for several different input words will now be described with reference to the accompanying timing diagram, figures 3A and 3B.

Step 1. At the start of decoding, the initial condition is that the Q output of the divide-by-two flip-flop 56 is high, its $\bar{Q}$ output is low and the Q output of each of each of flip-flop 64 and 66 is low. This may be achieved by holding the preset PR input of flip-flop 56 low for at least two clock periods or by presetting flip-flop 56 and clearing flip-flops 64 and 66.

Hence the output of OR gate 54 will be high – which enables AND gates 58 and 52, to feed input bits to the divide-by-two flip-flop 56 and the counter 36, respectively. Also, the outputs of flip-flops 64 and 66 will be low, thus forcing the outputs of AND gates 68 and 70 to be low, and the LOAD input of the counter 36 will be low, thereby loading it with (11111).

Step 2. The decoder must be initiated by a non-zero word before receiving the first word of serial data which may be a "zero" word. Otherwise if the first input words are zeroes, they will be ignored by the decoder. In normal operation of the VWL coder-decoder system, there will usually be a marker signal that indicates the start of the serial data. Obviously, this marker signal is a non-zero word.

Step 3. Just after the arrival of the first bit of the new word there will be a low to high transition of the delayed clock CLK2.

Assume the new word is non-zero, and has a value 111 as illustrated in the timing diagram, figures 3A and 3B.

The first bit of the new word will be high (the start bit). Hence the output signals 4 and 11 of AND gates 58 and 52 will be CLK2, (signal 4) and low, respectively. With the low to high transition of signal 4 at the CLK input of flip-flop 56, there will be a change in state of its outputs. Its Q output, signal 5, will go from high to low, and its $\bar{Q}$ output, signal 6, will go from low to high. Meanwhile the outputs of flip-flops 64 and 66 will remain low. Now the low at the Q output of flip-flop 56 will disable AND gate 60 preventing any output from the circuit. Also, both inputs of OR gate 54 are now low, so its output will be low, disabling gates 52 and 58.

The change of state of flip-flop 56 also causes the LOAD input of counter 36 to go high, and the invert input of OR gate 76 will thus be low.

Step 4. With the low to high transition of the second pulse of clock CLK2, the output of flip-flop 64 will change to high while that of flip-flop 66 will remain low. Hence a pulse will appear briefly at the output of AND gate to, thereby clearing the contents of counter 36. Also, the low to high transition of the output of flip-flop 64 appearing at the CLK input of flip-flop 78 will latch the second bit of the VWL serial data input word, which is the sign bit, into flip-flop 78. This is a (1) which will appear at the corresponding input of OR gate 76. Therefore, the level of its output will be the same as that of flip-flop 78 and hence the same as the sign bit.

Step 5a. With the positive-going edge of the third pulse of clock CLK2, the output of flip-flop 64 will remain high and that of flip-flop 66 will change from low to high. Hence the output of AND gate 68 will be high, changing the output of the OR gate 54 to high, thereby enabling AND gates 52 and 58.

As the present non-zero word is equal to –1 (i.e. "111"), the third input word bit will be high, indicating the end of the word.

Step 5b. Therefore, when gate 58 is enabled, a low to high transition of CLK2 will appear at the CLK input of flip-flop 56, thereby changing its state. Hence the Q output of flip-flop 56 will switch to high, enabling output AND gate 60. The counter 36 had merely been cleared so its output is (00000). The A input to the adder will be (100000). Therefore, the output of the adder 40 will be (100001) for a VWL input word 111 (i.e. –1). Then with the low to high transition of clock CLK3 appearing at the output of AND gate 60, the output of the adder 40 will be latched into flip-flop 44, and thence supplied from the decoder output to, for example, a buffer memory. Note that just after the latching of the output of adder 40 into flip-flop 44, the delayed $\bar{Q}$ output of flip-flop 56, which is low, will appear at the LOAD input of the counter 36, thereby loading it with (11111). The WL decoder is now ready to accept the first bit of new word and reverts to step 3, above.

If the input word is 101, representing +1, the sign bit is zero. Therefore the output of OR gate 76 will be a zero and the input to adder 40 will be (000000). Its output will be (000001).

Assume that the next word is zero as shown in figures 3A and 3B. It will comprise only one bit of low level. This will disable AND gate 58.

Consequently, the $\bar{Q}$ output of flip-flop 56 will remain low keeping the LOAD input of the counter 36 at low level. Hence the output of the counter will remain (11111) and the output of OR gate 76 will be high (due to its input being the inverse of the counter LOAD input). Therefore the A input of adder 40 is (111111). Af-

4

ter addition of decimal 1, the output of the adder will be (000000). Since the Q output of flip-flop 56 is now high, AND gate 60 is enabled. Thus with the positive-going edge of clock CLK3, the output of the adder will be latched into flip-flop 44 which provides the output of the decoder for application to the buffer memory (if required). The decoder will then revert to the beginning of step 3.

The next input word in figure 4 is equal to +2, i.e. (1001) so the input VWL word has zero or low bit after the sign bit. This means that steps 3 and 4 will be the same as described for an input word 111, except that the sign bit is different. Thereafter, the third bit, being low, will disable gate 58 and enable gate 52. Therefore the next low to high transition of clock signal 3 appears at the CLK input to the counter 36, thereby incrementing it by 1. The counter output, therefore, is equal to (00001).

Step 6. With the positive-going edge of the fourth pulse of clock CLK2, the outputs of flip-flops 64 and 66 will remain high, keeping AND gates 52 and 58 enabled. The word is equal to +2 so the fourth bit will be high indicating the end of the word. The process described in step 5b above will be repeated. However, in this case, since the counter has been incremented by 1, the output of the adder 40 will be (000010) for input word (1001).

If the input word is greater than +2 or −2, it will be handled in the same way, but for every additional zero in the input word there will be another low to high transition at the CLK input to the counter 36, incrementing it each time by 1. Therefore, the output of the counter 36 will be equal to the number of zeroes.

| INPUT LEVEL | SIGNED BINARY REPRESENTATION | OUTPUT - VARIABLE WORD LENGTH REPRESENTATION | WORD LENGTH |
|---|---|---|---|
| -n | s<br>i<br>g MAGNITUDE<br>n | s<br>i<br>g<br>n | n+2 |
| -13 | 1 0 1 1 0 1 | 1 1 0 0 0 0 0 0 0 0 0 0 0 1 | 15 |
| -12 | 1 0 1 1 0 0 | 1 1 0 0 0 0 0 0 0 0 0 0 1 | 14 |
| -11 | 1 0 1 0 1 1 | 1 1 0 0 0 0 0 0 0 0 0 1 | 13 |
| -10 | 1 0 1 0 1 0 | 1 1 0 0 0 0 0 0 0 0 1 | 12 |
| -9 | 1 0 1 0 0 1 | 1 1 0 0 0 0 0 0 0 1 | 11 |
| -8 | 1 0 1 0 0 0 | 1 1 0 0 0 0 0 0 1 | 10 |
| -7 | 1 0 0 1 1 1 | 1 1 0 0 0 0 0 1 | 9 |
| -6 | 1 0 0 1 1 0 | 1 1 0 0 0 0 1 | 8 |
| -5 | 1 0 0 1 0 1 | 1 1 0 0 0 0 1 | 7 |
| -4 | 1 0 0 1 0 0 | 1 1 0 0 0 1 | 6 |
| -3 | 1 0 0 0 1 1 | 1 1 0 0 1 | 5 |
| -2 | 1 0 0 0 1 0 | 1 1 0 1 | 4 |
| -1 | 1 0 0 0 0 1 | 1 1 1 | 3 |
| 0 | 0 0 0 0 0 0 | 0 | 1 |
| 1 | 0 0 0 0 0 1 | 1 0 1 | 3 |
| 2 | 0 0 0 0 1 0 | 1 0 0 1 | 4 |
| 3 | 0 0 0 0 1 1 | 1 0 0 0 1 | 5 |
| 4 | 0 0 0 1 0 0 | 1 0 0 0 0 1 | 6 |
| 5 | 0 0 0 1 0 1 | 1 0 0 0 0 0 1 | 7 |
| 6 | 0 0 0 1 1 0 | 1 0 0 0 0 0 0 1 | 8 |
| 7 | 0 0 0 1 1 1 | 1 0 0 0 0 0 0 0 1 | 9 |
| 8 | 0 0 1 0 0 0 | 1 0 0 0 0 0 0 0 0 1 | 10 |
| 9 | 0 0 1 0 0 1 | 1 0 0 0 0 0 0 0 0 0 1 | 11 |
| 10 | 0 0 1 0 1 0 | 1 0 0 0 0 0 0 0 0 0 0 1 | 12 |
| 11 | 0 0 1 0 1 1 | 1 0 0 0 0 0 0 0 0 0 0 0 1 | 13 |
| 12 | 0 0 1 1 0 0 | 1 0 0 0 0 0 0 0 0 0 0 0 0 1 | 14 |
| 13 | 0 0 1 1 0 1 | 1 0 0 0 0 0 0 0 0 0 0 0 0 0 1 | 15 |
| n | | | n+2 |

TABLE I.: Signed Binary Representation and VWL Representation of the Quantizer Levels

Note: 6-bit wide signed binary input is shown in the table. However, the width of the signs binary input can assume any value up to infinity.

EP 0 222 942 B1

| INPUT LEVEL | STEP # | INPUT B (MAGNITUDE) B₈ B₇\|B₆ ← B₁ | INPUT A (MAGNITUDE) A₆ A₅\|A₄ ← A₁ | SELECT INPUT (1=B, 0=A) | PROM address (MAGNITUDE) | PROM out & F.F. out FEEDBACK PART Q₆ Q₅ Q₄ ← Q₁ Q₀ |
|---|---|---|---|---|---|---|
| -8 | 1 | 1 0 1 0 1 0 0 0 | 1 X X X X X X X | B | 1 0 1 0 1 0 0 0 | 0 1 1 0 1 0 0 0 1 |
|  | 2 | 1 0 0 0 0 1 0 0 | 0 1 1 0 1 0 0 0 | A | 0 1 1 0 1 0 0 0 | 0 0 0 0 1 0 0 0 1 |
|  | 3 | 1 0 0 0 0 1 0 0 | 0 0 0 0 1 0 0 0 | A | 0 0 0 0 1 0 0 0 | 0 0 0 0 0 1 1 1 0 |
|  | 4 | 1 0 0 0 0 1 0 0 | 0 0 0 0 0 1 1 1 | A | 0 0 0 0 0 1 1 1 | 0 0 0 0 0 1 1 0 0 |
|  | 5 | 1 0 0 0 0 1 0 0 | 0 0 0 0 0 1 1 0 | A | 0 0 0 0 0 1 1 0 | 0 0 0 0 0 1 0 1 0 |
|  | 6 | 1 0 0 0 0 1 0 0 | 0 0 0 0 0 1 0 1 | A | 0 0 0 0 0 1 0 1 | 0 0 0 0 0 1 0 0 0 |
|  | 7 | 1 0 0 0 0 1 0 0 | 0 0 0 0 0 1 0 0 | A | 0 0 0 0 0 1 0 0 | 0 0 0 0 0 0 1 1 0 |
|  | 8 | 1 0 0 0 0 1 0 0 | 0 0 0 0 0 0 1 1 | A | 0 0 0 0 0 0 1 1 | 0 0 0 0 0 0 1 0 0 |
|  | 9 | 1 0 0 0 0 1 0 0 | 0 0 0 0 0 0 1 0 | A | 0 0 0 0 0 0 1 0 | 0 0 0 0 0 0 1 0 |
|  | 10 | 1 0 0 0 0 1 0 0 | 0 0 0 0 0 0 0 1 | A | 0 0 0 0 0 0 0 1 | 1 0 0 0 0 0 0 1 |
| +4 | 1 | 1 0 0 0 0 1 0 0 | 1 0 0 0 0 0 0 0 | B | 1 0 0 0 0 1 0 0 | 0 1 0 0 0 1 0 0 1 |
|  | 2 | 1 0 0 0 0 0 0 1 | 1 0 0 0 0 1 0 0 | A | 0 1 0 0 0 1 0 0 | 0 0 0 0 0 1 0 0 0 |
|  | 3 | 1 0 0 0 0 0 0 1 | 0 0 0 0 0 1 0 0 | A | 0 0 0 0 0 1 0 0 | 0 0 0 0 0 0 1 1 0 |
|  | 4 | 1 0 0 0 0 0 0 1 | 0 0 0 0 0 0 1 1 | A | 0 0 0 0 0 0 1 1 | 0 0 0 0 0 0 1 0 0 |
|  | 5 | 1 0 0 0 0 0 0 1 | 0 0 0 0 0 0 1 0 | A | 0 0 0 0 0 0 1 0 | 0 0 0 0 0 0 1 0 |
|  | 6 | 1 0 0 0 0 0 0 1 | 0 0 0 0 0 0 0 1 | A | 0 0 0 0 0 0 0 1 | 1 0 0 0 0 0 0 1 |
| +1 | 1 | 1 0 0 0 0 0 0 1 | 1 0 0 0 0 0 0 0 | B | 1 0 0 0 0 0 0 1 | 0 1 0 0 0 0 0 1 1 |
|  | 2 | 1 0 0 0 0 0 0 0 | 0 1 0 0 0 0 0 1 | A | 0 1 0 0 0 0 0 1 | 0 0 0 0 0 0 0 1 0 |
|  | 3 | 1 0 0 0 0 0 0 0 | 0 0 0 0 0 0 0 1 | A | 0 0 0 0 0 0 0 1 | 1 0 0 0 0 0 0 1 |
| 0 | 1 | 1 0 0 0 0 0 0 0 | 1 0 0 0 0 0 0 0 | B | 1 0 0 0 0 0 0 0 | 1 0 0 0 0 0 0 0 0 |
| 0 | 1 | 1 0 0 0 0 0 0 0 | 1 0 0 0 0 0 0 0 | B | 1 0 0 0 0 0 0 0 | 1 0 0 0 0 0 0 0 0 |
| -1 | 1 | 1 0 1 0 0 0 0 1 | 1 0 0 0 0 0 0 0 | B | 1 0 1 0 0 0 0 1 | 0 1 1 0 0 0 0 1 1 |
|  | 2 | 1 0 0 0 1 1 1 1 | 0 1 1 0 0 0 0 1 | A | 0 1 1 0 0 0 0 1 | 0 0 0 0 0 0 0 1 1 |
|  | 3 | 1 0 0 0 1 1 1 1 | 0 0 0 0 0 0 0 1 | A | 0 0 0 0 0 0 0 1 | 1 0 0 0 0 0 0 0 1 |

TABLE 2 - EXAMPLES TO ILLUSTRATE THE OPERATION OF THE VWL CODER

NOTE: These examples illustrate the operation of a VWL coder which operates for signed binary words of length 6 bits each. However, the VWL coder can operate for any size of signed binary input words.

X = irrelevant

**Claims**

1. Apparatus for decoding variable word length encoded serial binary data to provide for each variable length word a corresponding parallel binary output word, each non-zero value variable length word comprising a start bit and a stop bit of one state and a number of other bits of a different state, the number of said other bits representing the magnitude of the word, the apparatus comprising a binary counter and means responsive to a start bit of a non-zero value variable length word to be decoded for clearing the counter enabling the counter to count any said other bits present, responsive to a stop bit of said variable length word to output the contents of the counter as the corresponding parallel binary output word, and to load the counter with a predetermined number and responsive to a zero value variable length word comprising a single bit of said different state occurring after said stop bit and before a start bit of a following non-zero value variable length word to output said predetermined number from said counter as the corresponding binary output word.

2. Apparatus as defined in claim 1, wherein said predetermined number comprises all 1 bits ad said apparatus comprises means for adding a 1 bit to said predetermined number to provide an all-zero output word.

3. Apparatus as defined in claim 1, wherein the number of other bits is equal to one less than the magnitude, said apparatus further comprising adding means for adding unity to the output of the counter.

4. Apparatus as defined in claim 1, wherein said variable length word further comprises an additional bit, said apparatus comprising means for detecting said bit and for providing a corresponding bit for combination with the output of said counter.

5. Apparatus as defined in claim 4, wherein said additional bit represents polarity.

6. Apparatus as defined in any preceding claim wherein said means responsive comprises start and stop bit detection means and control means, said apparatus further comprising input means responsive to the input word stream, a periodic timing signal and to said control means, for supplying a signal corresponding to the input word stream selectively to said counter and to said start and stop bit detection means.

7. Apparatus as defined in claim 6, wherein said control means includes delay means responsive to an output from start and stop bit detection means representing a start bit to effect clearing of said counter in the next bit period.

8. Apparatus as defined in claim 7, for decoding words having a polarity bit following the start bit wherein said control means includes a second delay means, responsive to the first-mentioned delay means, and gating means operative when outputs of both delay means are the same to enable said input means to supply said signal to said counter and said detection means.

9. Apparatus as defined in claim 9, further comprising means for detecting said polarity bit and combining a corresponding bit with the output of said counter.

**Patentansprüche**

1. Vorrichtung zum Decodieren mit variabler Wortlänge codierter serieller Binärdaten, um für jedes Wort variabler Länge ein entsprechendes paralleles Binär-Ausgangswort zu erzeugen, wobei jedes Wort variabler Länge mit Nicht-Null-Wert ein Anfangsbit und ein Haltbit in einem Zustand und eine Anzahl anderer Bits in einem unterschiedlichen Zustand umfaßt, die Anzahl der anderen Bits die Größe des Wortes repräsentiert, die Vorrichtung einen Binärzähler und Mittel umfaßt, das auf ein Startbit eines zu decodierenden Wortes variabler Länge von Nicht-Null-Wert reagiert zum Löschen des Zählers, wodurch der Zähler zum Zählen irgendwelcher der anderen vorhandenen Bits freigegeben wird, und auf ein Haltbit des Wortes variabler Länge reagiert zum Ausgeben des Inhalts des Zählers als das entsprechende parallele Binärausgangswort und zum Beladen des Zählers mit einer vorbestimmten Zahl und auf ein Wort variabler Länge mit Null-Wert reagiert, mit einem einzigen nach dem Haltbit auftretenden Bit im unterschiedlichen Zustand und vor einem Anfangsbit eines folgenden Wortes variabler Länge mit Nicht-Null-Wert, um die vorbestimmte Zahl aus dem Zähler als das entsprechende Binär-Ausgangswort auszugeben.

2. Vorrichtung nach Anspruch 1, bei der die vorbestimmte Zahl lauter 1-Bits umfaßt und die Vorrichtung Mittel zum Addieren eines 1-Bit zu der vorbestimmten Zahl enthält, um ein Ausgangswort aus lauter Nullen zu schaffen.

3. Vorrichtung nach Anspruch 1, bei der die Anzahl der anderen Bits um eins geringer als die Größe ist, wobei die Vorrichtung weiter Addiermittel zum Addieren einer Einheit zum Ausgangssignal des Zählers umfaßt.

4. Vorrichtung nach Anspruch 1, bei der das Wort variabler Länge weiter ein zusätzliches Bit umfaßt und die Vorrichtung Mittel zum Erfassen des Bits enthält und zum Schaffen eines entsprechenden Bit zur Kombination mit dem Ausgangssignal des Zählers.

5. Vorrichtung nach Anspruch 4, bei der das zusätzliche Bit die Polarität repräsentiert.

6. Vorrichtung nach einem der vorangehenden Ansprüche, bei der das reagierende Mittel Anfangs- und Haltbit-Erfassungsmittel und Steuermittel umfaßt, die Vorrichtung weiter Eingangsmittel umfaßt, die auf den Eingangswortstrom, ein periodisches Zeitgabesignal und das Steuermittel reagieren zum selektiven Zuführen eines dem Eingangswortstrom entsprechenden Signals zu dem Zähler und zu dem Anfangs- und Haltbit-Erfassungsmittel.

7. Vorrichtung nach Anspruch 6, bei der das Steuermittel Verzögerungsmittel enthält, das auf ein Ausgangssignal vom Anfangs- und Haltbit-Erfassungsmittel reagiert, welches ein Anfangsbit repräsentiert, um ein Löschen des Zählers in der nächsten Bitzeitlänge zu bewirken.

8. Vorrichtung nach Anspruch 7 zum Decodieren von Worten mit einem auf das Anfangsbit folgenden Polaritätsbit, bei der das Steuermittel ein zweites Verzögerungsmittel enthält, das auf das ersterwähnte Verzögerungsmittel reagiert, und Gattermittel, die wirksam sind, wenn die Ausgangssignale beider Verzögerungsmittel gleich sind, das Eingangsmittel zum Zuführen des Signales zu dem Zähler und dem Erfassungsmittel freizugeben.

9. Vorrichtung nach Anspruch 8, weiter mit Mittel zum Erfassen des Polaritätsbits und Kombinieren eines entsprechenden Bits mit dem Ausgangssignal des Zählers.

## Revendications

1. Appareil pour décoder des données binaires sérielles codées à longueur de mot variable afin de fournir pour chaque mot de longueur variable un mot de sortie binaire parallèle correspondant, chaque mot de longueur variable de valeur non-zéro comprenant un bit de départ et un bit d'arrêt d'un certain état et un certain nombre d'autres bits d'un état différent, le nombre des autres bits représentant l'amplitude du mot, l'appareil comprenant un compteur binaire et un moyen répondant à un bit de départ d'un mot à longueur variable de valeur nonzéro pour être décodé afin d'effacer le compteur et de permettre à celui-ci de compter les autres bits présents, répondant à un bit d'arrêt du mot à longueur variable pour sortir les contenus du compteur comme étant le mot de sortie binaire parallèle correspondant, et pour charger le compteur avec un nombre prédéterminé et répondant à un mot de longueur variable de valeur zéro dudit état différent se produisant après le bit d'arrêt et avant un bit de départ d'un mot suivant de longueur variable de valeur non-zéro pour sortir du compteur le nombre prédéterminé comme étant le mot de sortie binaire correspondant.

2. Appareil selon la revendication 1, dans lequel le nombre prédéterminé ne comprend que des bits 1 et l'appareil comprend un moyen pour ajouter un bit 1 au nombre prédéterminé pour fournir un mot de sortie n'ayant que des zéros.

3. Appareil selon la revendication 1, dans lequel le nombre des autres bits est égal à un moins l'amplitude l'appareil comprenant en outre un moyen d'addition pour ajouter l'unité à la sortie du compteur.

4. Appareil selon la revendication 1, dans lequel le mot à longueur variable comprend en outre un bit supplémentaire, l'appareil comportant un moyen pour détecter ce bit et pour fournir un bit correspondant pour combinaison avec la sortie du compteur.

5. Appareil selon la revendication 4, dans lequel le bit supplémentaire représente la polarité.

6. Appareil selon l'une quelconque des revendications précédentes, dans lequel le moyen répondant comprend un moyen de détection de bit de départ et de bit d'arrêt et un moyen de commande, l'appareil comprenant en outre un moyen d'entrée répondant au train de mots d'entrée, à un signal périodique de synchronisation et au moyen de commande, pour fournir sélectivement au compteur et au moyen de détection de bit de départ et de bit d'arrêt un signal correspondant au train de mots d'entrée.

7. Appareil selon la revendication 6, dans lequel le moyen de commande comprend un moyen à retard répondant à une sortie du moyen de détection de bit de départ et de bit d'arrêt représentant un bit de départ pour effectuer l'effacement du compteur dans la période binaire suivante.

8. Appareil selon la revendication 7, pour décoder des mots ayant un bit de polarité suivant le bit de départ, dans lequel le moyen de commande comprend un second moyen à retard, répondant au moyen à retard mentionné en premier, et un moyen de déclenchement mis en œuvre lorsque les sorties des deux moyens à retard sont les mêmes pour permettre au moyen d'entrée de fournir le signal au compteur et au moyen de détection.

9. Appareil selon la revendication 8, comprenant en outre un moyen pour détecter le bit de polarité et pour combiner un bit correspondant avec la sortie du compteur.

**FIG. 1**

**FIG. 2**

# FIG. 3A

- ⓪ PR I/P OF f.f. 56
- ① CLK 1
- ② O/P OF f.f. NO. 0 (LATCHED SERIAL DATA I/P)
- ③ CLK 2
- ④ CLK I/P OF f.f. 56 ② AND ③ AND ⑩
- ⑤ Q O/P OF f.f. NO. 56
- ⑥ $\bar{Q}$ O/P OF f.f. NO. 56
- ⑦ Q O/P OF f.f NO. 64
- ⑧ Q O/P OF f.f NO. 66
- ⑨ O/P OF AND GATE NO. = ⑧ AND DELAY OF ⑦
- ⑩ O/P OF OR GATE NO.54 ⑤ OR ⑨
- ⑪ CLK I/P OF THE COUNTER 36 = ② AND ③ AND ⑩
- ⑫ INVERTED DELAYED Q O/P OF f.f. NO. 64 is DELAY INVERTED ⑦
- ⑬ O/P OF AND GATE NO.70 (CLR I/P OF THE COUNTER) = ⑫ AND ⑦
- ⑭ LOAD I/P OF THE COUNTER = DELAYED ⑥
- ⑮
- ⑯
- ⑰ } OUTPUTS OF COUNTER 36
- ⑱
- ⑲
- ⑳ O/P OF f.f.NO.72 = LATCHED ② BY TRANSITION OF ⑨
- ㉑ INVERT INPUT OF OR GATE 76 = DELAYED ⑤
- ㉒ O/P OF OR GATE NO.76 = ⑳ OR ㉑
- ㉓ DELAYED CLK 3
- ㉔ O/P LATCH CLK = O/P OF AND GATE NO. 60 = ⑤ AND ㉓

TO FIG.3B

EP 0 222 942 B1

FIG.3B

FROM FIG.3A